# EUROPEAN PATENT APPLICATION

(11) **EP 4 464 732 A1**
(43) Date of publication of application: **20.11.2024**
(21) Application number: 22893971.6
(22) Date of filing: 12.12.2022
(51) Int. Cl.: C08G 59/40, C09J 163/02, C09J 171/00, C08L 63/00, C08L 71/10, C09J 7/30, H01L 21/52

(54) **RESIN COMPOSITION FOR FLEXIBLE DEVICE, FILM-LIKE ADHESIVE FOR FLEXIBLE DEVICE, ADHESIVE SHEET FOR FLEXIBLE DEVICE, AND METHOD FOR MANUFACTURING FLEXIBLE DEVICE**

(30) Priority: 13.01.2022 JP 2022003639
(71) Applicant: Furukawa Electric Co., Ltd., Tokyo 100-8322 (JP)
(72) Inventor: SAKAI, Koyuki, Tokyo 100-8322 (JP)
(74) Representative: Forstmeyer, Dietmar
(86) International application number: PCT/JP2022/045721
(87) International publication number: WO 2023/136017

(57) **Abstract**

A resin composition for a flexible device, containing an epoxy resin and a phenoxy resin, wherein a cured product of the resin composition has a glass transition temperature of 60°C or higher, and the cured product has a storage modulus of 5.0 GPa or less,
a film-like adhesive using the resin composition,
an adhesive sheet having a laminated structure of the film-like adhesive and
a flexible base material, and a method of producing a flexible device.

## Description

### FIELD OF THE INVENTION

The present invention relates to a resin composition for a flexible device, a film-like adhesive for a flexible device, an adhesive sheet for a flexible device, and a method of producing a flexible device.

### BACKGROUND OF THE INVENTION

A flexible device such as a flexible display is produced by forming semiconductor elements such as an organic electroluminescence (organic EL) element, a liquid crystal panel, a micro light emitting diode (micro LED), and a transistor (these are collectively referred to as a functional element) on a flexible support base material (flexible base material or flexible film). Recently, in application to a display of a mobile terminal such as a smartphone, a phablet, or a tablet, a foldable flexible device that can be folded or rolled is required.

As described above, such a flexible device includes a flexible base material (back plate) as a support base material that supports the entire device in order to increase the strength of a device main body and impart reliability. That is, the functional element is fixed onto the flexible base material, and the flexible device is produced. On both surfaces of the functional element, various functional layers (for example, a protective layer, a gas barrier layer (sealing layer), a polarizing plate, and a hard coat layer) are usually laminated, and the entire laminate including the functional element is integrally disposed on the flexible base material and fixed via a paste-like or film-like adhesive. As the flexible base material, a polyethylene terephthalate film, a polyimide film, or the like is used.

In production of a flexible device, an adhesive sheet used for adhesion between layers of a laminated structure has been proposed. For example, Patent Literature 1 describes an adhesive sheet for sealing a device, including a first release film, a second release film, and an adhesive layer sandwiched therebetween. This adhesive layer contains a compound having a cyclic ether group, and a storage modulus thereof at 23°C is adjusted to 9.5 × 10⁵ Pa or more and 3.0 × 10⁷ Pa or less. According to the technique described in Patent Literature 1, peelability of the release film from the adhesive layer is excellent even when the adhesive sheet is cut, and this adhesive layer is also excellent in adhesiveness to an adherend.

### CITATION LIST

### PATENT LITERATURE

Patent Literature 1: WO 2020/251030 A

### SUMMARY OF INVENTION

### TECHNICAL PROBLEM

In production of a flexible device, a film-like adhesive used for adhesion between layers of a laminated structure needs not only to be simply curved but also to have high flex resistance to withstand repeated severe bending.

Meanwhile, there is a demand for use of a flexible device under a high-temperature and/or high-humidity environment from a viewpoint of expanding an application of the flexible device. Specifically, in an application such as an in-vehicle device (for example, a car navigation system or an electric component disposed in an engine room or the like), a device used outdoors, a device used in a bathroom, a home appliance, or a wearable device, it is conceivable that a device itself is placed under a high temperature and/or high humidity environment or the temperature of the device itself becomes high due to heat generated from the inside during use. For example, in a vehicle in which an in-vehicle device is disposed, it is not uncommon that the temperature exceeds 50°C and the humidity exceeds 75%. In order to improve reliability of a flexible device in such a high temperature/high humidity environment, there is a demand for an adhesive whose adhesive strength is less likely to decrease even in the above-described environment.

There is room for improvement in an adhesive made of a conventional resin composition including the composition described in Patent Literature 1 from a viewpoint of simultaneously achieving both the high flex resistance and heat resistance/moisture resistance.

The present invention contemplates providing a resin composition for a flexible device capable of forming an adhesive layer having both excellent heat resistance/moisture resistance and excellent flex resistance, and a film-like adhesive using the resin composition. Further, the present invention contemplates providing an adhesive sheet for a flexible device having a laminated structure of the film-like adhesive and a flexible base material. Furthermore, the present invention contemplates providing a method of producing a flexible device using the resin composition, the film-like adhesive, or the adhesive sheet.

### SOLUTION TO PROBLEM

The above problems of the present invention have been solved by the following means.
[1] A resin composition for a flexible device, containing:
   an epoxy resin; and
   a phenoxy resin,

   wherein a cured product of the resin composition has a glass transition temperature of 60°C or higher, and
   wherein the cured product has a storage modulus of 5.0 GPa or less.
[2] The resin composition for a flexible device described in [1], wherein the epoxy resin has an epoxy equivalent of 170 g/eq or more.
[3] The resin composition for a flexible device described in [1] or [2], wherein the epoxy resin contains an epoxy resin having a bisphenol structure.
[4] The resin composition for a flexible device described in [1] or [2], wherein the epoxy resin contains an epoxy resin having an alicyclic structure.
[5] The resin composition for a flexible device described in any one of [1] to [4], wherein the epoxy resin contains an epoxy resin having a hydrogenated bisphenol structure.
[6] The resin composition for a flexible device described in any one of [1] to [5], containing a silane coupling agent.
[7] The resin composition for a flexible device described in any one of [1] to [6], which is energy ray-curable.
[8] A film-like adhesive for a flexible device, which is obtainable by using the resin composition for a flexible device described in any one of [1] to [7].
[9] An adhesive sheet for a flexible device, having a structure which is obtainable by laminating a flexible base material and the film-like adhesive for a flexible device described in [8].
[10] The adhesive sheet for a flexible device described in [9], wherein the film-like adhesive for a flexible device has a thickness of 1 to 100 µm.
[11] The adhesive sheet for a flexible device described in [9] or [10], wherein the adhesive sheet for a flexible device has a thickness of 1 to 500 µm.
[12] A method of producing a flexible device, including using the resin composition described in any one of [1] to [7], the film-like adhesive for a flexible device described in [8], or the adhesive sheet for a flexible device described in any one of [9] to [11] for adhesion between layers constituting the flexible device.
[13] A method of producing a flexible device, including using the resin composition described in any one of [1] to [7] or the film-like adhesive for a flexible device described in [8] for sealing a constituent material of the flexible device.
[14] A method of producing a flexible device, including forming a support base material of the flexible device with the adhesive sheet for a flexible device described in any one of [9] to [11].

In the present invention, the numerical ranges expressed with the term "to" refer to ranges including, as the lower limit and the upper limit, the numerical values before and after the term "to".

### ADVANTAGEOUS EFFECTS OF INVENTION

By forming a film using a resin composition for a flexible device of the present invention, a film-like adhesive for a flexible device, having both excellent heat resistance/moisture resistance and excellent flex resistance can be obtained. In addition, a film-like adhesive for a flexible device and an adhesive sheet for a flexible device of the present invention exhibit excellent heat resistance/moisture resistance and excellent flex resistance. In addition, a method of producing a flexible device of the present invention can further enhance adhesion reliability of a flexible device to be obtained.

### BRIEF DESCRIPTION OF DRAWINGS

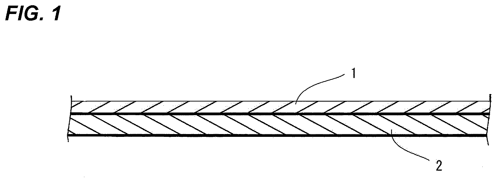

{FIG. 1}
FIG. 1 is a cross-sectional view schematically illustrating a laminated structure of an adhesive sheet for a flexible device of the present invention.

### DESCRIPTION OF EMBODIMENTS

### [Resin composition for flexible device]

A resin composition for a flexible device (hereinafter, also simply referred to as "resin composition") of the present invention contains an epoxy resin and a phenoxy resin. A cured product of the resin composition of the present invention has a glass transition temperature (Tg) of 60°C or higher, and the cured product has a storage modulus of 5.0 GPa or less. As a result, the resin composition of the present invention can make the cured product after a curing reaction have both desired high heat resistance/moisture resistance and flex resistance.

Therefore, the resin composition of the present invention is suitable for bonding a constituent material of a flexible device and sealing a constituent material of the flexible device. The resin composition of the present invention can be suitably used particularly for a flexible device used at a high temperature/high humidity, for example, an in-vehicle device (for example, a car navigation system or a display for advertisement), a device used in a bathroom, a device used outdoors, a home appliance, or a wearable device.

Tg is a temperature (peak top temperature) at which tan δ indicates a maximum value during viscoelasticity measurement by dynamic viscoelasticity measurement (DMA).

Here, the cured product of the resin composition of the present invention having Tg of X°C means that when the cured product has two or more values of Tg, the lowest value of Tg is X°C. Therefore, the cured product of the film-like adhesive of the present invention having Tg of 60°C or higher means that when the cured product has two or more values of Tg, the lowest value of Tg is 60°C or higher.

Tg of the cured product is 60°C or higher, preferably 80°C or higher, preferably 80 to 150°C, more preferably 90 to 140°C, still more preferably 90 to 130°C, further still more preferably 90 to 120°C, further still more preferably 100 to 120°C, and further still more preferably 100 to 115°C. Tg of the cured product can also be 110 to 120°C.

The cured product of the resin composition has a storage modulus of 5.0 GPa or less. By setting the storage modulus to 5.0 GPa or less, it is possible to make peeling less likely to occur due to bending of the flexible device. The storage modulus of the cured layer is preferably 4.8 GPa or less, also preferably 4.0 GPa or less, also preferably 3.5 GPa or less, and also preferably 3.0 GPa or less. In addition, the storage modulus of the cured layer is usually 0.5 GPa or more, and in consideration of heat resistance/moisture resistance, the storage modulus is also preferably 0.7 GPa or more, also preferably 0.8 GPa or more, and also preferably 0.9 GPa or more. The storage modulus of the cured layer is preferably 0.5 to 5.0 GPa, more preferably 0.7 to 5.0 GPa or less, still more preferably 0.8 to 4.8 GPa, also preferably 0.8 to 4.0 GPa, also preferably 0.8 to 3.5 GPa, also preferably 0.8 to 3.0 GPa, also preferably 0.8 to 2.5 GPa, also preferably 0.9 to 2.2 GPa, and also preferably 1.0 to 2.0 GPa.

The storage modulus of the cured product of the resin composition can be controlled by the chemical structure (skeleton, type of functional group, and the like), molecular weight, epoxy equivalent, content, and the like of the epoxy resin, the chemical structure (skeleton, type of functional group, and the like), molecular weight, glass transition temperature, content, and the like of the phenoxy resin, the type, content, and the like of an inorganic filler, a curing agent, or another additive in the cured product.

The Tg and storage modulus are determined as follows.

An adhesive having a thickness of 0.5 mm is formed using an adhesive composition, and a curing reaction is caused under a curing condition (i) or (ii) described later. The obtained cured product sample is cut into a width of 5 mm and used as a measurement sample. Viscoelastic behavior of the adhesive cured product is measured when the temperature is raised from -40°C to 250°C under a tensile condition of a distance between chucks of 20 mm and a frequency of 10 Hz and a temperature raising rate of 5°C/min using a dynamic viscoelasticity measurement apparatus RSAIII (manufactured by TA Instruments), and the storage modulus at 23°C and Tg are determined.
(i) In a case of an energy ray-curable type (typically, a form including a photocationic polymerization initiator):
   a condition of ultraviolet irradiation using a mercury lamp under an irradiation condition of 1,000 mJ/cm² at 23°C.
(ii) In a case of a thermosetting type (typically, a form including a latent curing agent or a thermal cationic polymerization initiator):
   heat treatment condition at 150°C for one hour.

The curing reaction of the resin composition of the present invention can sufficiently proceed under the above curing condition (i) or (ii), and a cured product having a crosslinked structure introduced therein can be obtained. Note that the above (i) and (ii) are intended to clarify the characteristics of the resin composition of the present invention, and the curing condition is not limited to the above (i) or (ii) in a scene where the resin composition of the present invention is actually used.

The resin composition can be suitably used as an adhesive. That is, the resin composition forms a crosslinked structure and is cured by a curing reaction to exhibit adhesive strength to an adherend.

Hereinafter, each component contained in the resin composition will be described.

### (Epoxy resin)

The resin composition of the present invention contains at least one type of epoxy resin.

The epoxy resin may be any resin as long as the epoxy resin has an epoxy group, and an epoxy resin that can be used for an adhesive can be widely used. The epoxy resin forms a crosslinked structure in the resin composition by a reaction between an epoxy group and a reactive group of another component or ring-opening polymerization between epoxy groups.

The epoxy resin has an epoxy equivalent of preferably 100 to 3,000 g/eq, more preferably 200 to 1,500 g/eq.

The epoxy equivalent of the epoxy resin is preferably 170 g/eq or more, more preferably 190 to 2,000 g/eq, and still more preferably 200 to 1,000 g/eq from a viewpoint of reducing an increase in storage modulus to enhance flex resistance.

When the epoxy resin does not have an alicyclic structure, the epoxy equivalent is preferably large. For example, the epoxy equivalent is preferably 500 g/eq or more, more preferably 600 to 1,000 g/eq, still more preferably 650 to 900 g/eq, and further still more preferably 700 to 850 g/eq.

Conversely, when the epoxy resin has an alicyclic structure, the epoxy equivalent can be made smaller. For example, the epoxy equivalent is preferably less than 500 g/eq, more preferably 100 to 400 g/eq, still more preferably 120 to 350 g/eq, further still more preferably 130 to 300 g/eq, and further still more preferably 150 to 260 g/eq.

Note that, in the present invention, the epoxy equivalent refers to the number of grams of a resin containing 1 gram equivalent of epoxy group (g/eq).

Examples of the skeleton of the epoxy resin include a phenol novolac type, an orthocresol novolac type, a cresol novolac type, a dicyclopentadiene type, a biphenyl type, a fluorene bisphenol type, a triazine type, a naphthol type, a naphthalene diol type, a triphenylmethane type, a tetraphenyl type, a bisphenol A type, a bisphenol F type, a bisphenol AD type, a bisphenol S type, and a trimethylolmethane type. Among these skeletons, a triphenylmethane type, a bisphenol A type, a cresol novolac type, and an orthocresol novolac type are preferable from a viewpoint of being capable of obtaining a film-like adhesive having low resin crystallinity and good appearance.

The epoxy resin is preferably an epoxy resin having a bisphenol structure.

In addition, the epoxy resin is also preferably an epoxy resin having an alicyclic structure, more preferably a hydrogenated (hydrogenated) bisphenol type epoxy resin (an epoxy resin having a hydrogenated bisphenol structure), and still more preferably a hydrogenated bisphenol A type epoxy resin. By using an epoxy resin having an alicyclic structure, better flex resistance can be achieved even if values of Tg and storage modulus of cured products are at the same level.

The epoxy resin has a molecular weight of preferably 100 to 3,000, more preferably 200 to 1,500.

The content of the epoxy resin in the solid content (components other than a solvent) of the resin composition is preferably 10 to 70% by mass, preferably 15 to 65% by mass, more preferably 20 to 60% by mass, still more preferably 22 to 55% by mass, and further still more preferably 30 to 55% by mass.

### (Phenoxy resin)

The resin composition of the present invention contains at least one type of phenoxy resin.

The phenoxy resin is a component that suppresses film tackiness at normal temperature (23°C) and imparts film formation property (film formability) when a film-like adhesive is formed.

Note that, in the present invention, the phenoxy resin is one having an epoxy equivalent (mass of resin per equivalent of epoxy group) of more than 3,000 g/eq. That is, a resin having an epoxy equivalent of 3000 g/eq or less even though having a phenoxy resin structure is classified as an epoxy resin.

The phenoxy resin can be obtained by a usual method. For example, the phenoxy resin can be obtained by a reaction of a bisphenol or a biphenol compound with an epihalohydrin such as epichlorohydrin, or a reaction of a liquid epoxy resin with a bisphenol or a biphenol compound.

The phenoxy resin has glass transition temperature (Tg) of preferably 140°C or lower, more preferably 120°C or lower, still more preferably 100°C or lower, particularly preferably 90°C or lower. Tg of the phenoxy resin is also preferably 0°C or higher, also preferably 10°C or higher, also preferably 20°C or higher, and may be 30°C or higher, 40°C or higher, 50°C or higher, or 60°C or higher. Tg of the phenoxy resin is also preferably 0 to 100°C, also preferably 10 to 90°C, also preferably 20 to 90°C, also preferably 30 to 90°C, also preferably 40 to 90°C, also preferably 50 to 90°C, and also preferably 60 to 90°C.

As the phenoxy resin, a plurality of phenoxy resins having different values of Tg can be used in combination. For example, a phenoxy resin having Tg of 60 to 90°C and a phenoxy resin having Tg of 10 to 30°C can be used in combination.

Tg of the phenoxy resin is a peak top temperature of tan δ in dynamic viscoelasticity measurement. Specifically, Tg can be determined as follows.

### -Method of determining Tg-

A solution obtained by dissolving the phenoxy resin therein is applied onto a release film, and heated and dried to form a film (polymer film) made of the polymer component on the release film. The release film is peeled off and removed from this polymer film. This polymer film is measured by using a dynamic viscoelasticity measurement apparatus (trade name: Rheogel-E4000F, manufactured by UBM) under a condition of a measurement temperature range of 20 to 300°C, a temperature raising rate of 5°C/min, and a frequency of 1 Hz. The obtained tan δ peak top temperature (temperature at which tan δ indicates maximum) is defined as Tg.

The phenoxy resin usually has a mass average molecular weight of 10,000 or more. The upper limit is not particularly limited, but is practically 5,000,000 or less.

The mass average molecular weight of the phenoxy resin is determined by GPC (Gel Permeation Chromatography) in terms of polystyrene.

For example, the content of the phenoxy resin in the resin composition can be 40 to 500 parts by mass, may be 60 to 400 parts by mass or 70 to 300 parts by mass, and is also preferably 80 to 250 parts by mass with respect to 100 parts by mass of the epoxy resin.

### (Curing agent)

The resin composition of the present invention preferably contains a curing agent of the epoxy resin. As the curing agent of the epoxy resin, a curing agent generally used as a curing agent of an epoxy resin, such as amines, acid anhydrides, polyhydric phenols, and a cationic polymerization initiator (preferably a photocationic polymerization initiator), can be widely used. When an organic EL device is assumed as the flexible device, since an adherend to be bonded with the resin composition of the present invention is weak against heat, it may be unsuitable to use a thermal cationic polymerization initiator as the curing agent. In addition, the thermal cationic polymerization initiator tends to excessively increase the elastic modulus of a cured layer to be obtained, and it is not suitable to use the thermal cationic polymerization initiator as the curing agent also from this viewpoint. Therefore, the curing agent is preferably a photocationic polymerization initiation or a latent curing agent. When a photocationic polymerization initiator is used as the curing agent, the resin composition and the film-like adhesive of the present invention are energy ray-curable. Examples of the energy ray include a light ray such as an ultraviolet ray and an ionizing radiation such as an electron beam.

Examples of the latent curing agent include a dicyandiamide compound, an imidazole compound, a curing catalyst-complex polyhydric phenol compound, a hydrazide compound, a boron trifluoride-amine complex, an aminimide compound, a polyamine salt, and modified products or microcapsules thereof. These may be used singly, or in combination of two or more types thereof. Use of an imidazole compound is more preferable from a viewpoint of providing even better latency (properties of excellent stability at room temperature and exhibiting curability by heating) and providing a more rapid curing rate.

The content of the curing agent in the resin composition only needs to be appropriately set according to the type and reaction form of the curing agent. For example, the content can be 0.5 to 30 parts by mass, may be 1 to 20 parts by mass or 1 to 15 parts by mass, and is also preferably 2 to 10 parts by mass or also preferably 3 to 8 parts by mass with respect to 100 parts by mass of the epoxy resin.

### (Other components)

The resin composition may contain a silane coupling agent. The silane coupling agent is a compound in which at least one hydrolyzable group such as an alkoxy group or an aryloxy group is bonded to a silicon atom. In addition to these groups, an alkyl group, an alkenyl group, or an aryl group may be bonded to the silicon atom. The alkyl group is preferably an alkyl group substituted with an amino group, an alkoxy group, an epoxy group, or a (meth)acryloyloxy group, and more preferably an alkyl group substituted with an amino group (preferably, a phenylamino group), an alkoxy group (preferably, a glycidyloxy group), or a (meth)acryloyloxy group.

Examples of the silane coupling agent include 2-(3,4-epoxycyclohexyl) ethyltrimethoxysilane, 3-glycidyloxypropyltrimethoxysilane, 3-glycidyloxypropyltriethoxysilane, 3-glycidyloxypropylmethyldimethoxysilane, 3-glycidyloxypropylmethyldiethoxysilane, dimethyldimethoxysilane, dimethyldiethoxysilane, methyltrimethoxysilane, methyltriethoxysilane, phenyltrimethoxysilane, phenyltriethoxysilane, N-phenyl-3-aminopropyltrimethoxysilane, 3-methacryloyloxypropylmethyldimethoxysilane, 3-methacryloyloxypropyltrimethoxysilane, 3-methacryloyloxypropylmethyldiethoxysilane, and 3-methacryloyloxypropyltriethoxysilane.

The resin composition may further contain an organic solvent, an ion trapping agent (ion capturing agent), a curing catalyst, a viscosity adjusting agent, an antioxidant, a flame retardant, a coloring agent, and an inorganic filler, and the like. The adhesive layer can contain, for example, other additives described in WO 2017/158994 A.

The total proportion of the contents of the epoxy resin, the curing agent thereof, and the phenoxy resin in the resin composition can be, for example, 30% by mass or more, and is preferably 40% by mass or more and more preferably 50% by mass or more. The proportion may be 60% by mass or more, 70% by mass or more, 80% by mass or more, or 90% by mass or more.

### [Film-like adhesive for flexible device]

The film-like adhesive for a flexible device (hereinafter, also referred to as "film-like adhesive") of the present invention is a film-like adhesive formed using the resin composition of the present invention. That is, the film-like adhesive of the present invention can be obtained by forming a film using the resin composition of the present invention and removing a solvent as necessary. The film-like adhesive of the present invention is in a state before curing, that is, in a state of B-stage. As described above, a cured product of the film-like adhesive of the present invention has Tg of 60°C or higher and a storage modulus of 5.0 GPa or less. The above description of Tg and the storage modulus in the cured product of the resin composition of the present invention can be applied to Tg and the storage modulus of the cured product of the film-like adhesive of the present invention, and preferable ranges thereof are also similar.

When the film-like adhesive of the present invention is formed using a resin composition for a flexible device, containing an organic solvent, the solvent is usually removed from the composition for an adhesive by drying. Therefore, the content of the solvent in the film-like adhesive of the present invention is 1,000 ppm (ppm is on a mass basis) or less, and is usually 0.1 to 1,000 ppm.

Here, the "film" in the present invention means a thin film having a thickness of 200 µm or less. The shape, size, and the like of the film are not particularly limited, and can be appropriately adjusted according to a use form.

The thickness of each of the film-like adhesive and a cured layer obtained by curing the film-like adhesive is usually 1 to 100 µm, preferably 2 to 80 µm, and also preferably 5 to 50 µm.

The film-like adhesive of the present invention can be obtained on a release film or a desired base material by preparing a composition (varnish) obtained by mixing the constituent components of the resin composition of the present invention, applying the composition onto the release film or the desired base material, and drying the composition as necessary. The composition (varnish) obtained by mixing the constituent components of the resin composition of the present invention usually contains an organic solvent.

A publicly known method can be appropriately employed as an application method, and examples thereof include methods using a roll knife coater, a gravure coater, a die coater, a reverse coater, and the like.

Drying only needs to be able to form the film-like adhesive by removing the organic solvent without substantially causing a curing reaction, and can be performed, for example, by holding the composition at a temperature of 80 to 150°C for 1 to 20 minutes.

The film-like adhesive of the present invention is preferably stored under a temperature condition of 10°C or lower before use (before curing reaction) from a viewpoint of suppressing a curing reaction of the film-like adhesive (curing reaction of the epoxy resin). In addition, when the film-like adhesive of the present invention is energy ray-curable, the film-like adhesive is preferably stored in a light-shielding manner before use. A temperature condition at the time of light-shielding storage is not particularly limited, and the film-like adhesive may be stored at room temperature or may be refrigerated.

### [Adhesive sheet for flexible device]

The adhesive sheet for a flexible device (hereinafter, also simply referred to as "adhesive sheet") of the present invention has a structure formed by laminating a flexible base material (flexible film) and the film-like adhesive (adhesive layer) of the present invention.

### <Flexible base material>

The material, thickness, and the like of the flexible base material constituting the adhesive sheet of the present invention are not particularly limited as long as the flexible base material has flexibility and can be used as a support base material of a flexible device. That is, a flexible base material used for a flexible device can be widely applied.

The flexible base material has a storage modulus of preferably 10 GPa or less, more preferably 7 GPa or less, still more preferably 5 GPa or less. The storage modulus is usually 0.01 GPa or more, also preferably 0.05 GPa or more, and also preferably 0.1 GPa or more. The storage modulus of the flexible base material is a storage modulus at 23°C when the flexible base material is cut into a width of 5 mm, and the temperature thereof is raised from -20°C to 150°C under a tensile condition of a distance between chucks of 20 mm and a frequency of 10 Hz and a temperature raising rate of 5°C/min using a dynamic viscoelasticity measurement apparatus RSAIII (manufactured by TA Instruments).

Preferable examples of a material of the flexible base material include a polyester resin, a polyimide resin, an acrylic resin (a polymethyl methacrylate (PMMA) resin and the like), a polycarbonate resin, an acrylonitrile/butadiene/styrene copolymer (ABS) resin, a polyolefin resin (a polypropylene resin, a polyethylene resin, and the like), a polyamide resin, a polyurethane resin, a polyvinyl alcohol (PVA) resin, a polystyrene resin, a polyphenylene sulfide (PPS) resin, and a polyether ether ketone (PEEK) resin. Among these materials, a polyester resin or a polyimide resin is preferable. Preferable examples of the polyester resin include a polyethylene terephthalate resin and a polyethylene naphthalate resin.

The flexible base material has a thickness of usually 1 to 1,000 µm, preferably 5 to 800 µm, also preferably 5 to 400 µm, also preferably 5 to 200 µm, also preferably 10 to 100 µm. The thickness can be measured by a contact type linear gauge method (desk-top contact type thickness measurement apparatus).

The entire thickness of the adhesive sheet of the present invention including the film-like adhesive and the flexible base material is preferably 1 to 1,100 µm and more preferably 1 to 500 µm.

As described above, the adhesive sheet of the present invention can be formed by preparing a composition (varnish) obtained by mixing the constituent components of the film-like adhesive of the present invention (resin composition of the present invention), applying the composition onto a flexible base material, and drying the composition as necessary.

The adhesive sheet of the present invention may have a configuration including a flexible base material and a film-like adhesive, or may be in a form in which a release film is further bonded to a surface of the film-like adhesive on a side opposite to the flexible base material side. In addition, a protective film or the like may be formed on a surface of the flexible base material on a side opposite to the film-like adhesive side. In addition, the adhesive sheet of the present invention may be in a form obtained by cutting the sheet into an appropriate size or a form obtained by winding the sheet into a roll form.

The adhesive sheet of the present invention is preferably stored under a temperature condition of 10°C or lower before use (before curing reaction) from a viewpoint of suppressing a curing reaction of the film-like adhesive (curing reaction of the epoxy resin). In addition, when the film-like adhesive is energy ray-curable, the adhesive sheet of the present invention is preferably stored in a light-shielding manner before use. A temperature condition at the time of light-shielding storage is not particularly limited, and the film-like adhesive may be stored at room temperature or may be refrigerated.

### [Method of producing flexible device]

The method of producing a flexible device of the present invention is not particularly limited as long as the method is a method of producing a flexible device using any one of the resin composition of the present invention, the film-like adhesive of the present invention, and the adhesive sheet of the present invention.

An embodiment of the method of producing a flexible device of the present invention includes using the resin composition of the present invention, the film-like adhesive of the present invention, or the adhesive sheet of the present invention for adhesion between layers constituting the flexible device.

The layers constituting the flexible device, to which the resin composition of the present invention, the film-like adhesive of the present invention, or the adhesive sheet of the present invention is applied are not particularly limited, and examples thereof include laminates each including a functional element (laminates each formed of a functional element and various functional layers disposed on one or both surfaces of the functional element), a flexible base material and a laminate including a functional element, and a first flexible base material and a second flexible base material (a laminate including a functional element may be further formed on a side of either or each of the first and second flexible base materials opposite to the adhesive). Therefore, an embodiment of the method of producing a flexible device of the present invention includes a step of disposing the film-like adhesive of the present invention on a surface of one layer constituting the flexible device, disposing another layer constituting the flexible device with the film-like adhesive interposed therebetween, and causing the film-like adhesive to undergo a curing reaction.

In addition, by using the adhesive sheet of the present invention as a support base material of a flexible device, the adhesive sheet of the present invention can be used for adhesion between layers constituting the flexible device. That is, the flexible base material constituting the adhesive sheet can be used as a support base material (back plate) that supports the entire flexible device, and the film-like adhesive of the adhesive sheet can function as a layer for bonding the support base material to a laminate including a functional element thereon. Therefore, the method of producing a flexible device of the present invention includes, in an embodiment thereof, a step of forming a support base material of the flexible device with the adhesive sheet of the present invention, that is, a step of bonding the film-like adhesive side of the adhesive sheet of the present invention to a laminate including a functional element and causing the film-like adhesive to undergo a curing reaction.

Another embodiment the method of producing a flexible device of the present invention includes using the resin composition of the present invention or the film-like adhesive of the present invention for sealing a constituent material of the flexible device.

The constituent material of the flexible device to which the resin composition of the present invention or the film-like adhesive of the present invention is applied is not particularly limited, and examples thereof include a functional element (an organic electroluminescent element, a semiconductor element, a liquid crystal element, a micro LED, or the like). Specifically, the resin composition of the present invention or the film-like adhesive of the present invention is applied to a surface or the like of an object such as a functional element, and seals the object. Therefore, an embodiment of the method of producing a flexible device of the present invention includes a step of disposing the resin composition of the present invention or the film-like adhesive of the present invention on a surface of a constituent material of the flexible device, and causing the resin composition or the film-like adhesive to undergo a curing reaction.

In the method of producing a flexible device of the present invention, conditions for the curing reaction can be appropriately set in consideration of the type of curing agent, heat resistance of the functional element, and the like. For example, when a photocationic polymerization initiator is used as the curing agent, the adhesive can be sufficiently cured by irradiating the adhesive with ultraviolet rays of 100 to 3,000 mJ/cm² using a mercury lamp or the like. In addition, when a latent curing agent or a thermal cationic polymerization initiator is used, for example, the adhesive can be sufficiently cured by heating the adhesive at a temperature of 150°C or higher for one hour or more.

### EXAMPLES

The present invention will be described in more detail based on Examples and Comparative Examples. However, the present invention is not limited to forms of the following Examples. In addition, the room temperature means 23°C, MEK means methyl ethyl ketone, PET means polyethylene terephthalate, and UV means ultraviolet rays. "%" and "part" are on a mass basis unless otherwise specified.

### (Example 1)

In a 1,000 ml separable flask, 50 parts by mass of ST-3000 (trade name, hydrogenated bisphenol A type liquid epoxy resin, manufactured by NIPPON STEEL CHEMICAL & MATERIALS CO., LTD.), 50 parts by mass of YP-50 (trade name, phenoxy resin, manufactured by NIPPON STEEL CHEMICAL & MATERIALS CO., LTD.) as a polymer component, and 30 parts by mass of MEK were heated and stirred at a temperature of 110°C for two hours to obtain a resin varnish. Furthermore, this resin varnish was transferred to a 800 ml planetary mixer, 2 parts by mass of WPI-113 (trade name, UV cationic polymerization initiator, manufactured by FUJIFILM Wako Pure Chemical Corporation) was added thereto as a curing agent, and the mixture was stirred and mixed at room temperature for one hour and then vacuum-defoamed to obtain a mixed varnish (resin composition). Subsequently, the obtained mixed varnish was applied onto a 38 µm-thick PET film (release film) that had been subjected to surface release treatment, and heated and dried at 130°C for 10 minutes to obtain a film-like adhesive with a release film, having a length of 300 mm, a width of 200 mm, and an adhesive thickness of 20 µm.

### [Example 2]

A film-like adhesive with a release film was obtained in a similar manner to Example 1 except that 35 parts by mass of 828 (trade name, bisphenol A type epoxy resin, manufactured by Nippon Steel Chemical & Materials Co., Ltd.) was used as the epoxy resin and the blending amount of the polymer component was changed to 65 parts by mass.

### [Example 3]

A film-like adhesive with a release film was obtained in a similar manner to Example 1 except that the blending amount of the epoxy resin was changed to 35 parts by mass and the blending amount of the polymer component was changed to 65 parts by mass.

### [Example 4]

A film-like adhesive with a release film was obtained in a similar manner to Example 1 except that 50 parts by mass of 828 (trade name, bisphenol A type epoxy resin, manufactured by Nippon Steel Chemical & Materials Co., Ltd.) was used as the epoxy resin.

### [Example 5]

A film-like adhesive with a release film was obtained in a similar manner to Example 1 except that 50 parts by mass of 1003 (trade name, bisphenol A type epoxy resin, manufactured by Mitsubishi Chemical Corporation) was used as the epoxy resin.

### [Example 6]

A film-like adhesive with a release film was obtained in a similar manner to Example 1 except that 2 parts by mass of 2E4MZ (trade name, imidazole-based thermosetting agent, manufactured by Shikoku Chemicals Corporation) was used as the curing agent.

### [Example 7]

A film-like adhesive with a release film was obtained in a similar manner to Example 1 except that 1 part by mass of KBM-402 (trade name, silane coupling agent, manufactured by Shin-Etsu Chemical Co., Ltd.) was added to the mixed varnish.

### [Example 8]

A film-like adhesive with a release film was obtained in a similar manner to Example 1 except that 10 parts by mass of YP-50 (trade name, phenoxy resin, manufactured by Nippon Steel Chemical & Materials Co., Ltd.) and 40 parts by mass of YX7180 (trade name, phenoxy resin, manufactured by Mitsubishi Chemical Corporation) were used as the polymer component.

### [Example 9]

A film-like adhesive with a release film was obtained in a similar manner to Example 1 except that the blending amount of the epoxy resin was changed to 20 parts by mass and the blending amount of the polymer component was changed to 80 parts by mass.

### [Comparative Example 1]

A film-like adhesive with a release film was obtained in a similar manner to Example 1 except that 50 parts by mass of acrylic resin (SG-708-6 (trade name), acrylic resin, manufactured by Nagase ChemteX Corporation) was used as the polymer component in place of the phenoxy resin.

### [Comparative Example 2]

A film-like adhesive with a release film was obtained in a similar manner to Example 1 except that 700 parts by mass (350 parts by mass as silica) of SIRMEK50WT%-M01 (trade name, silica slurry filler, manufactured by CIK Nanotech Co., Ltd.) was added to the mixed varnish.

### [Comparative Example 3]

A film-like adhesive with a release film was obtained in a similar manner to Example 1 except that 50 parts by mass of EPPN-501H (trade name, triphenylmethane type epoxy resin, manufactured by Nippon Kayaku Co., Ltd.) was used as the epoxy resin.

### [Comparative Example 4]

A film-like adhesive with a release film was obtained in a similar manner to Example 1 except that 50 parts by mass of EPPN-501H (trade name, triphenylmethane type epoxy resin, manufactured by Nippon Kayaku Co., Ltd.) was used as the epoxy resin, 143 parts by mass (50 parts by mass as a phenoxy resin) of YX7200B35 (trade name, a mixed solution of a phenoxy resin and a solvent, manufactured by Mitsubishi Chemical Corporation) was used as the polymer component, and 2 parts by mass of SI-B3 (thermal cationic polymerization initiator, manufactured by Sanshin Chemical Industry Co., Ltd.) was used as the curing agent.

### [Comparative Example 5]

A film-like adhesive with a release film was obtained in a similar manner to Example 1 except that 143 parts by mass (50 parts by mass as a phenoxy resin) of YX7200B35 (a mixed solution of a phenoxy resin and a solvent, manufactured by Mitsubishi Chemical Corporation) was used as the polymer component, and 2 parts by mass of SI-B3 (thermal cationic polymerization initiator, manufactured by Sanshin Chemical Industry Co., Ltd.) was used as the curing agent.

### [Comparative Example 6]

A film-like adhesive with a release film was obtained in a similar manner to Example 1 except that 25 parts by mass of 1003 (trade name, bisphenol A type epoxy resin, manufactured by Mitsubishi Chemical Corporation) and 25 parts by mass of ST-3000 (trade name, hydrogenated bisphenol A type liquid epoxy resin, manufactured by Nippon Steel Chemical & Materials Co., Ltd.) were used as the epoxy resin, 35 parts by mass of YP-50 (trade name, phenoxy resin, manufactured by Nippon Steel Chemical & Materials Co., Ltd.) and 15 parts by mass of YX7180 (trade name, phenoxy resin, manufactured by Mitsubishi Chemical Corporation) were used as the polymer component, and 200 parts by mass (100 parts by mass as silica) of SIRMEK50WT%-M01 (trade name, silica slurry filler, manufactured by CIK Nanotech Co., Ltd.) was added to the mixed varnish.

The glass transition temperature and the storage modulus of a cured product of the film-like adhesive with a release film obtained in each of Examples and Comparative Examples were measured. Furthermore, using the film-like adhesive with a release film obtained in each of Examples and Comparative Examples, evaluation of flex resistance and evaluation of heat resistance/moisture resistance were performed as follows. The results are shown in the following Table. Note that, as a curing condition in physical property values and the evaluations, (i) or (ii) described above was employed depending on the type of curing agent. The employed curing conditions are also shown in Table below.

### <Measurement of glass transition temperature and storage modulus of cured product>

The film-like adhesive obtained in each of Examples and Comparative Examples was laminated at 70°C using a laminator until the thickness reached 0.5 mm in a state where the release film was peeled off. A laminate of an adhesive cured product obtained by curing this laminate under the above curing condition (i) or (ii) was cut into a width of 5 mm and used as a measurement sample. Viscoelastic behavior of the adhesive cured product was measured when the temperature was raised from -40°C to 250°C under a tensile condition of a distance between chucks of 20 mm and a frequency of 10 Hz and a temperature raising rate of 5°C/min using a dynamic viscoelasticity measurement apparatus RSAIII (manufactured by TA Instruments), and the storage modulus at 23°C and Tg were determined. Tg was defined as a temperature at which tanδ indicated a maximum value, and when there were two or more maximum values, a temperature at which tanδ indicated a maximum value on the lowest temperature side was defined as Tg. The measurement results are shown in Table 1.

### <Evaluation of flex resistance>

The film-like adhesive with a release film obtained in each of Examples and Comparative Examples was bonded to a PET film (flexible base material, storage modulus at 23°C: 5 GPa) having a thickness of 20 µm, and the release film was peeled off to obtain an adhesive sheet having a structure in which the flexible base material and the film-like adhesive (adhesive layer) were laminated. This adhesive sheet was cut into a width of 25 mm and a length of 10 cm, and was cured under the curing condition (i) or (ii) described above to obtain a test piece. The adhesive layer was set on a side opposite to the mandrel based on an intermediate point of the test piece in the longitudinal direction, and an operation of bending the test piece by 180° was repeated 1,000 times. The diameter (mm) of the mandrel in which breakage of the adhesive layer, a fold mark of the adhesive layer, or peeling between the adhesive layer and the flexible base material occurred was applied to the following evaluation criteria, and flex resistance was evaluated. Evaluation C or higher was regarded as acceptable.

The results are shown in Table 1.

### (Evaluation criteria)

A: 4 mm or less
B: 5 mm or more and 14 mm or less
C: 15 mm or more and 29 mm or less
D: 30 mm or more, or not bendable

### <Evaluation of moisture resistance/heat resistance>

The film-like adhesive with a release film obtained in each of Examples and Comparative Examples was cut into a width of 25 mm and a length of 10 cm, and bonded to a silicon wafer at a bonding temperature of 70°C, a bonding pressure of 0.5 MPa, and a bonding speed of 10 mm/sec, and the release film was peeled off. Thereafter, curing was performed under the curing condition (i) or (ii) described above to obtain a test piece (silicon wafer with a film-like adhesive). The obtained silicon wafer with a film-like adhesive was held in a thermo-hygrostat set at a temperature of 60°C and a humidity of 90% for 100 hours. Adhesive strength between the silicon wafer and the film-like adhesive before and after holding was measured with a tensile tester, and moisture resistance/heat resistance was evaluated using a change ratio in adhesive strength before and after holding as an index. Evaluations A and B were regarded as acceptable. The results are shown in Table 1.

Test conditions of the adhesive strength were as follows.
Test speed: 50 mm/sec
Peeling angle: 90°

One end of the film-like adhesive was peeled off from the silicon wafer, and this one end was folded back by 90°. The silicon wafer was fixed to a lower jig disposed in a tensile tester, the one end of the film-like adhesive was fixed to an upper jig, and the silicon wafer and the film-like adhesive were pulled at the above test speed such that a peeling angle between the silicon wafer and the film-like adhesive was 90°. Average peeling strength [N/25 mm] at the time of peeling was measured and used as adhesive strength. Change ratio = [{(adhesive strength before holding) - (adhesive strength after holding)}/(adhesive strength before holding)] × 100 [%]

### (Evaluation criteria)

A: A change ratio is less than 5%
B: A change ratio is 5% or more and less than 20%
C: A change ratio is 20% or more

### [Table 1]

**Table 1**

| | | Ex. 1 | Ex. 2 | Ex. 3 | Ex. 4 | Ex. 5 | Ex. 6 | Ex. 7 | Ex. 8 | Ex. 9 |
|---|---|---|---|---|---|---|---|---|---|---|
| Epoxy resin | 1003 (Bisphenol A type epoxy resin, 770 g/eq) | | | | | 50 | | | | |
| | ST-3000 (Hydrogenated bisphenol A type epoxy resin, 225 g/eq) | 50 | | 35 | | | 50 | 50 | 50 | 20 |
| | 828 (Bisphenol A type epoxy resin, 185 g/eq) | | 35 | | 50 | | | | | |
| | EPPN-501H (Triphenylmethane type epoxy resin, 165 g/eq) | | | | | | | | | |
| Polymer component | YP-50 (Phenoxy resin, Tg 84°C) | 50 | 65 | 65 | 50 | 50 | 50 | 50 | 10 | 80 |
| | YX7200B35 (Phenoxy resin, Tg 150°C) | | | | | | | | | |
| | YX7180 (Phenoxy resin, Tg 15°C) | | | | | | | | 40 | |
| | SG-708-6 (Acrylic resin) | | | | | | | | | |
| Curing agent | WPI-113 (UV cationic polymerization initiator) | 2 | 2 | 2 | 2 | 2 | | 2 | 2 | 2 |
| | SI-B3 (Thermal cationic polymerization initiator) | | | | | | | | | |
| | 2E4MZ (Imidazole-based thermosetting agent) | | | | | | 2 | | | |
| Additive | KBM-402 (Silane coupling agent) | | | | | | | 1 | | |
| Filler | SIRMEK50WT%-M01 (Silica slurry) | | | | | | | | | |
| Curing condition | | (i) | (i) | (i) | (i) | (i) | (ii) | (i) | (i) | (i) |
| Tg of cured product [°C] | | 105 | 105 | 115 | 115 | 100 | 110 | 105 | 65 | 100 |
| Storage modulus of cured product [GPa] | | 1.5 | 1.5 | 3.0 | 3.0 | 1.0 | 2.0 | 1.5 | 0.8 | 4.8 |
| Evaluation of moisture resistance/ heat resistance | | A | A | A | A | A | A | A | B | A |
| Flex resistance evaluation | | A | C | A | C | B | A | A | A | A |

| | | | | | | | | | | |
|---|---|---|---|---|---|---|---|---|---|---|
| Remarks: 'Ex.' means Example according to this invention. | | | | | | | | | | |

**Table 1 (Continued-1)**

| | | CEx. 1 | CEx. 2 | CEx. 3 | CEx. 4 | CEx. 5 | CEx. 6 |
|---|---|---|---|---|---|---|---|
| Epoxy resin | 1003 (Bisphenol A type epoxy resin, 770 g/eq) | | | | | | 25 |
| | ST-3000 (Hydrogenated bisphenol A type epoxy resin, 225 g/eq) | 50 | 50 | | | 50 | 25 |
| | 828 (Bisphenol A type epoxy resin, 185 g/eq) | | | | | | |
| | EPPN-501H (Triphenylmethane type epoxy resin, 165 g/eq) | | | 50 | 50 | | |
| Polymer component | YP-50 (Phenoxy resin, Tg 84°C) | | 50 | 50 | | | 35 |
| | YX7200B35 (Phenoxy resin, Tg 150°C) | | | | 50 | 50 | |
| | YX7180 (Phenoxy resin, Tg 15°C) | | | | | | 15 |
| | SG-708-6 (Acrylic resin) | 50 | | | | | |
| Curing agent | WPI-113 (UV cationic polymerization initiator) | 2 | 2 | 2 | | | 2 |
| | SI-B3 (Thermal cationic polymerization initiator) | | | | 2 | 2 | |
| | 2E4MZ (Imidazole-based thermosetting agent) | | | | | | |
| Additive | KBM-402 (Silane coupling agent) | | | | | | |
| Filler | SIRMEK50WT%-M01 (Silica slurry) | | 350 | | | | 100 |
| Curing condition | | (i) | (ii) | (ii) | (ii) | (ii) | (i) |
| Tg of cured product [°C] | | 5 | 135 | 140 | 155 | 150 | 105 |
| Storage modulus of cured product [GPa] | | 0.7 | 15 | 5.5 | 7.0 | 6.0 | 6.0 |
| Evaluation of moisture resistance/ heat resistance | | C | A | A | A | A | A |
| Flex resistance evaluation | | A | D | D | D | D | D |

| | | | | | | | |
|---|---|---|---|---|---|---|---|
| Remarks: "CEx.' means Comparative Example. | | | | | | | |

In Table above, the blending amount of each component of the adhesive is indicated by parts by mass. An empty space means that a corresponding component is not contained.

As shown in Table above, when the glass transition temperature of a cured product of a resin composition was lower than that specified in the present invention, a change ratio in adhesive strength was 20% or more, and the cured product was poor in heat resistance/moisture resistance (Comparative Example 1). When the storage modulus of the cured product was higher than that specified in the present invention, breakage or a fold mark of the adhesive layer easily occurred against repeated bending, and the cured product was poor in flex resistance (Comparative Examples 2 to 6).

Meanwhile, all of the resin compositions of Examples 1 to 9 satisfying the requirements of the present invention exhibited excellent heat resistance/moisture resistance and flex resistance. It is found that reliability of a flexible device can be enhanced by using the resin composition of the present invention, a film-like adhesive formed using the resin composition of the present invention, or an adhesive sheet including the film-like adhesive in production of the flexible device.

In addition, it is found that when a resin composition containing an epoxy resin having an alicyclic structure is used, flex resistance can be achieved at a higher level even if values of storage modulus and Tg of cured products are the same (Comparison between Examples 1 and 2 and comparison between Examples 3 and 4).

The present invention has been described together with embodiments thereof. It is our intention that the invention should not be limited by any of the details of the description unless otherwise specified, but rather be construed broadly within its spirit and scope as set out in the attached claims.

The present application claims priority of Patent Application No. 2022-003639 filed in Japan on January 13, 2022, which is herein incorporated by reference as part of the present specification.

### DESCRIPTION OF SYMBOLS

- 1: Adhesive layer (film-like adhesive)
- 2: Flexible base material (Support base material)

## Claims

1. A resin composition for a flexible device, comprising:
an epoxy resin; and
a phenoxy resin,
wherein a cured product of the resin composition has a glass transition temperature of 60°C or higher, and
wherein the cured product has a storage modulus of 5.0 GPa or less.

2. The resin composition for a flexible device according to claim 1, wherein the epoxy resin has an epoxy equivalent of 170 g/eq or more.

3. The resin composition for a flexible device according to claim 1 or 2, wherein the epoxy resin comprises an epoxy resin having a bisphenol structure.

4. The resin composition for a flexible device according to claim 1 or 2, wherein the epoxy resin comprises an epoxy resin having an alicyclic structure.

5. The resin composition for a flexible device according to any one of claims 1 to 4, wherein the epoxy resin comprises an epoxy resin having a hydrogenated bisphenol structure.

6. The resin composition for a flexible device according to any one of claims 1 to 5, comprising a silane coupling agent.

7. The resin composition for a flexible device according to any one of claims 1 to 6, which is energy ray-curable.

8. A film-like adhesive for a flexible device, which is obtainable by using the resin composition for a flexible device according to any one of claims 1 to 7.

9. An adhesive sheet for a flexible device, having a structure which is obtainable by laminating a flexible base material and the film-like adhesive for a flexible device according to claim 8.

10. The adhesive sheet for a flexible device according to claim 9, wherein the film-like adhesive for a flexible device has a thickness of 1 to 100 µm.

11. The adhesive sheet for a flexible device according to claim 9 or 10, wherein the adhesive sheet for a flexible device has a thickness of 1 to 500 µm.

12. A method of producing a flexible device, comprising using the resin composition according to any one of claims 1 to 7, the film-like adhesive for a flexible device according to claim 8, or the adhesive sheet for a flexible device according to any one of claims 9 to 11 for adhesion between layers constituting the flexible device.

13. A method of producing a flexible device, comprising using the resin composition according to any one of claims 1 to 7 or the film-like adhesive for a flexible device according to claim 8 for sealing a constituent material of the flexible device.

14. A method of producing a flexible device, comprising forming a support base material of the flexible device with the adhesive sheet for a flexible device according to any one of claims 9 to 11.
